# EUROPÄISCHE PATENTANMELDUNG

(11) **EP 4 796 680 A1**
(43) Veröffentlichungstag der Anmeldung: **26.08.2026**
(21) Anmeldenummer: 26159381.8
(22) Anmeldetag: 18.02.2026
(51) Int. Cl.: C30B 25/18, C30B 29/04, C23C 16/27

(54) **VERFAHREN ZUR HETEROEPITAKTISCHEN ABSCHEIDUNG VON DIAMANT UND DAMIT HERGESTELLTER WAFER**

(30) Priorität: 20.02.2025 DE 102025106576
(71) Anmelder: Fraunhofer-Gesellschaft zur Förderung der angewandten Forschung e.V., 80686 München (DE)
(72) Erfinder: KUSTERMANN, Jan, 79108 Freiburg (DE); ENGELS, Jan, 79108 Freiburg (DE)
(74) Vertreter: Friese Goeden Patentanwälte PartGmbB

(57) **Zusammenfassung**

Die Erfindung betrifft ein Verfahren zur heteroepitaktischen Abscheidung von Diamant (1) auf einem Substrat (2) mittels chemischer Gasphasenabscheidung (CVD), enthaltend folgende Schritte:
a. Erzeugen (51) einer Nukleationsschicht auf dem Substrat (2);
b. Überwachsen (52) der Nukleationsschicht mit einer Diamantschicht (15, 16) durch chemische Gasphasenabscheidung;
c. Teilweises Entfernen (53) der Diamantschicht (15, 16) durch trockenchemisches Ätzen, wobei das trockenchemische Ätzen durch Einwirken eines Plasmas (3) erfolgt, welches Wasserstoff und Sauerstoff enthält oder daraus besteht;
d. Überwachsen (54) der Diamantschicht (15, 16) durch chemische Gasphasenabscheidung
e. Zyklisches Wiederholen der Verfahrensschritte c und d. Weiterhin betrifft die Erfindung einen solchermaßen Hergestellten Wafer, welcher Diamant enthält oder daraus besteht.

## Beschreibung

Die Erfindung betrifft ein Verfahren zur heteroepitaktischen Abscheidung von Diamant auf einem Substrat mit chemischer Gasphasenabscheidung, enthaltend folgende Schritte: Erzeugen einer Nukleationsschicht auf dem Substrat und Überwachsen der Nukleationsschicht mit einer Diamantschicht durch chemische Gasphasenabscheidung. Weiterhin betrifft die Erfindung einen Wafer mit einem Durchmesser von 5 cm oder mehr und einer Dicke von 200 µm oder mehr, welcher Diamant enthält oder daraus besteht. Verfahren dieser Art können zur homoepitaktischen oder heteroepitaktischen Abscheidung von Diamant verwendet werden. Die solchermaßen hergestellten Wafer, welche Diamant enthalten oder daraus bestehen, können unter anderem zur Herstellung von elektronischen Bauelementen oder als Fenster mit niedrigem Absorptionskoeffizient für elektromagnetische Strahlung verwendet werden.

Aus der Praxis ist bekannt, Diamant mittels einer Niederdrucksynthese abzuscheiden. Hierzu wird ein Plasma verwendet, dessen Arbeitsgas zumindest Wasserstoff und einen Kohlenwasserstoff enthält. Das Substrat, auf welchem Diamant abgeschieden wird, wird auf eine Temperatur über 650°C beheizt. Hierdurch können einkristalline, polykristalline oder amorphe Kohlenstoffschichten abgeschieden werden, welche ganz oder teilweise aus sp³-hybridisiertem Kohlenstoff bestehen. Diese bekannten Verfahren weisen den Nachteil auf, dass bei der Heteroepitaxie auf Fremdsubstraten hohe mechanische Spannungen in der abgeschiedenen Schicht entstehen, welche ab einer gewissen Schichtdicke zur Rissbildung in der Diamantschicht oder zum Ablösen der Diamantschicht vom Substrat führen können.

Zur Lösung dieses Problems ist aus der DE 10 2022 205 081 A1 bekannt, das Substrat bei Raumtemperatur derart vorzukrümmen, dass durch die Verformungen, die während des Aufwachsens der Diamantschicht auftreten, eine im Wesentlichen ebene Substratoberfläche entsteht. Diamantschichten können dadurch auf einer ebenen Substratoberfläche aufgewachsen werden, so dass die Erzeugung ebener einkristalliner Diamantschichten auf großen Flächen ermöglicht wird.

Dieses bekannte Verfahren weist den Nachteil auf, dass die Herstellung eines bei Raumtemperatur gekrümmten Substrates durch spanende Bearbeitung sehr aufwendig ist. Darüber hinaus muss die Krümmung für jede Temperatur und jede Schichtdicke neu bestimmt werden.

Ausgehend vom Stand der Technik kann der Erfindung somit die Aufgabe zugrunde liegn, ein Verfahren anzugeben, mit welchem ebene Diamantschichten hoher kristalliner Qualität in einfacher Weise und reproduzierbar hergestellt werden können.

Nachfolgend wird ein Verfahren gemäß Anspruch 1 und ein Wafer nach Anspruch 12 beschrieben.

Gemäß einem Aspekt wird ein Verfahren zur heteroepitaktischen Abscheidung von Diamant beschrieben. Eine heteroepitaktische Abscheidung bedeutet dabei, dass eine Schicht erzeugt wird, welche im Wesentlichen Diamant enthält oder daraus besteht, wobei die Abscheidung auf einem Substrat erfolgt, welches aus einem von Diamant veschiedenen Material besteht. Das Substrat kann polygonal oder rund sein. Die Oberfläche des Substrates kann im Wesentlichen eben sein. Ein ebenes Substrat soll für die Zwecke der vorliegenden Beschreibung ein Substrat sein, welches einen Krümmungsradius bzw. Krümmungsradien von mehr als etwa 5 m aufweist. In einigen Ausführungsformen der Erfindung kann der Krümmungsradius größer als etwa 10 m oder größer als etwa 20 m oder größer als etwa 100 m sein.

Das Substrat kann monokristallin oder polykristallin oder amorph sein. Das Substrat kann ein homogenes Material enthalten oder daraus bestehen. In anderen Ausführungsformen der Erfindung kann das Substrat selbst nochmals beschichtet sein bzw. aus mehreren Schichten zusammengesetzt sein.

In einigen Ausführungsformen der Erfindung kann das Substrat ein einkristalliner Silizium-Wafer sein bzw. einen Silizium-Wafer enthalten. In anderen Ausführungsformen der Erfindung kann das Substrat Strontiumtitanat oder Aluminiumnitrid oder Zirkonoxid enthalten oder daraus bestehen. Keramische Substrate können darüber hinaus Yttrium enthalten. Weiterhin kann das Substrat Iridium enthalten oder daraus bestehen. In einigen Ausführungsformen der Erfindung kann das Substrat einen Silizium-Wafer enthalten, welcher mit Yttrium-stabilisiertem Zirkonoxid und/oder Aluminiumnitrid beschichtet ist. Auf dieser Schicht kann Iridium aufgebracht sein. Der Silizium-Wafer kann eine Dicke von etwa 0,5 mm bis etwa 5 mm oder von etwa 2 mm bis etwa 5 mm oder von etwa 0,5 mm bis etwa 3 mm oder von etwa 2 mm bis etwa 3 mm aufweisen. Die aufgebrachten Schichten aus Yttrium-stabilisiertem Zirkonoxid und Iridium können eine Schichtdicke von etwa 80 nm bis etwa 200 nm oder von etwa 80 nm bis etwa 150 nm oder von etwa 110 nm bis etwa 130 nm aufweisen.

Zur Durchführung des vorgeschlagenen Verfahrens kann das Substrat in eine Vakuumkammer eingebracht und auf eine erhöhte Temperatur gebracht werden. Die Temperatur kann zwischen etwa 650°C und etwa 1200°C oder zwischen etwa 750°C und etwa 950°C oder zwischen etwa 800°C und etwa 900°C oder zwischen etwa 840°C und etwa 860°C betragen. Das Substrat kann mittels einer elektrischen Spannungsquelle auf ein vorgebbares elektrisches Potential gebracht werden. Weiterhin kann sich die Vakuumkammer in einem Mikrowellenresonator befinden oder Teil eines Mikrowellenresonators sein oder in ihrem Innenraum mit einer Antenne versehen sein, durch welche Mikrowellenstrahlung eingekoppelt werden kann. Die Mikrowellenstrahlung ist dazu eingerichtet und bestimmt, ein in die Vakuumkammer eingebrachtes Arbeitsgas zu ionisieren und hierdurch zu aktivieren. Die solchermaßen erzeugten Ionen, Elektronen und/oder Photonen werden zumindest teilweise auf die Oberfläche des Substrates gelenkt, um auf diese Weise die Abscheidung von Diamant auf dem Substrat zu ermöglichen. Die Mikrowellenstrahlung kann eine Frequenz zwischen etwa 900 MHz und etwa 950 MHz oder zwischen etwa 2,4 GHz und etwa 2,5 GHz aufweisen.

In einem ersten Verfahrensschritt wird zunächst eine Nukleationsschicht auf dem Substrat erzeugt. Die Nukleationsschicht kann durch Aufbringen von Nanodiamanten bzw. Diamantstaub oder Diamantgranulat auf der Oberfläche hergestellt werden. In anderen Ausführungsformen der Erfindung kann die Nukleationsschicht in an sich bekannter Weise aus einem vorstehend beschriebenen Plasma bzw. aus der Gasphase erzeugt werden, wobei eine elektrische Vorspannung an das Substrat angelegt werden kann. Die Vorspannung kann in einigen Ausführungsformen der Erfindung eine negative Vorspannung sein. Weiterhin kann zur Herstellung der Nukleationsschicht ein Plasma bzw. eine Gasphase verwendet werden, welches im Wesentlichen Wasserstoff und Methan enthält, wobei der Methan-Anteil zwischen etwa 1% und etwa 5% betragen kann. Das Erzeugen der Nukleationsschicht kann bei diesen Bedingungen zwischen etwa 0,1 h und etwa 3 h oder etwa 0,5 h bis etwa 2 h oder etwa 0,75 h bis etwa 1,5 h andauern. Die Nukleationsschicht muss - unbeschadet der Bezeichnung als Schicht - nicht geschlossen sein. Es kann sich um eine Teilbeschichtung des Substrates oder einzelne Inseln bz. Flecken auf der Oberfläche des Subbstrates handeln.

Im zweiten Verfahrensschritt kann die Nukleationsschicht mit einer Diamantschicht überwachsen werden. Die Diamantabscheidung kann in einigen Ausführungsformen der Erfindung mit einer definierten elektrischen Vorspannung erfolgen. In einigen Ausführungsformen der Erfindung kann die Abscheidung auf einem Substrat erfolgen, welches elektrisch isolierend innerhalb der Vakuumkammer aufgenommen ist, wobei sich in Abhängigkeit der Plasmabedingungen ein elektrisches Potential auf dem Substrat einstellt, welches vom Erdpotential der umgebenden Vakuumkammer verschieden sein kann. In einigen Ausführungsformen der Erfindung kann das Herstellen der Diamantschicht aus einer Gasphase erfolgen, welche im Wesentlichen Wasserstoff und einen Kohlenwasserstoff enthält. Der Kohlenwasserstoff kann Methan oder Ethan oder Acetylen sein oder enthalten. Der Anteil des Kohlenwasserstoffes kann zwischen etwa 1% und etwa 5% oder zwischen etwa 1% und etwa 3,5% oder zwischen etwa 1,25% und etwa 1,75% oder zwischen etwa 3% und etwa 3,5% betragen. Der zweite Verfahrensschritt kann so lange andauern, bis die Nukleationsschicht vollständig mit einer Diamantschicht überwachsen ist bzw. die Diamantschicht auf dem Substrat geschlossen ist, so dass keine Punkteffekte oder Löcher in der Diamantschicht verbleiben. Dies kann zwischen etwa 1 Stunden und etwa 6 Stunden oder zwischen etwa 3 Stunden und etwa 5 Stunden oder zwischen etwa 3,5 Stunden und etwa 4,5 Stunden andauern.

In einigen Ausführungsformen kann in einem dritten Verfahrensschritt die im vorhergehenden Verfahrensschritt hergestellte Diamantschicht durch trockenchemisches Ätzen teilweise entfernt werden. Das trockenchemische Ätzen kann durch Einwirken eines Plasmas erfolgen, welches Wasserstoff oder Wasserstoff und Sauerstoff enthält. Der Sauerstoff-Anteil kann in einigen Ausführungsformen zwischen etwa 0,3% und etwa 3% oder zwischen etwa 1,5% und etwa 2,5% oder zwischen etwa 1,8% und etwa 2,2% betragen. Der Sauerstoff-Anteil kann in anderen Ausführungsformen größer als etwa 0,3% oder größer als etwa 0,5% oder größer als etwa 0,8% oder größer als etwa 1,0% sein. Der Sauerstoff-Anteil kann geringer als etwa 3% oder geringer als etwa 2,5% oder geringer als etwa 2,25% oder geringer als etwa 2,1% sein. Das trockenchemische Ätzen kann zwischen etwa 2 Stunden und etwa 5 Stunden andauern.

Nach dem teilweisen Entfernen der Diamantschicht im dritten Verfahrensschritt kann die so entstandene Oberfläche im vierten Verfahrensschritt erneut mit einer Diamantschicht durch chemische Gasphasenabscheidung überwachsen werden. Das Überwachsen im vierten Verfahrensschritt kann mit identischen oder ähnlichen Parametern erfolgen, wie das Überwachsen der Nukleationsschicht im zweiten Verfahrensschritt. Nach dem Herstellen der weiteren Diamantschicht kann auch diese durch trockenchemisches Ätzen teilweise entfernt werden, wie vorstehend beschrieben. Nachfolgend kann das Wachsen von Diamantschichten gemäß dem vierten Verfahrensschritt und das teilweise Entfernen der Diamantschicht durch trockenchemisches Ätzen gemäß dem dritten Verfahrensschritt zyklisch wiederholt werden. In einigen Ausführungsformen wird im dritten Verfahrensschritt die im vorhergehenden Verfahrensschritt aufgewachsene Diamantschicht nur teilweise entfernt, so dass die Gesamtschichtdicke der zyklisch gewachsenen und entfernten Diamantschichten stetig ansteigt.

Das zyklische Wiederholen der Verfahrensschritte kann so lange erfolgen, bis die Gesamtschichtdicke des so erzeugten Diamant mehr als etwa 200 µm oder mehr als etwa 300 µm oder mehr als etwa 400 µm beträgt. In einigen Ausführungsformen kann durch das zyklische Aufwachsen und Entfernen der Diamantschichten die auftretende mechanische Spannung reduziert werden, so dass auch vergleichsweise große Schichtdicken auf großflächigen Substraten erzeugt werden können, ohne dass diese sich in unerwünschter Weise vom Substrat ablösen oder durch Risse beschädigt werden oder der Wafer eine unzulässig große Krümmung erfährt.

In einigen Ausführungsformen der Erfindung kann das teilweise Entfernen der Diamantschicht und das anschließende Überwachsen mit einer weiteren Diamantschicht etwa 10 Mal bis etwa 80 Mal wiederholt werden. In anderen Ausführungsformen der Erfindung kann das teilweise Entfernen der Diamantschicht und das nachfolgende Überwachsen zwischen etwa 20 Mal und etwa 60 Mal wiederholt werden. In wiederum anderen Ausführungsformen der Erfindung kann das teilweise Entfernen der Diamantschicht und das anschließende Überwachsen zwischen etwa 30 Mal und etwa 60 Mal wiederholt werden. In einigen Ausführungsformen der Erfindung kann hierdurch eine Gesamtdicke des Diamant von mehr als 200 µm oder mehr als 300 µm oder mehr als 400 µm erzielt werden. In einigen Ausführungsformen der Erfindung kann der Diamant eine geringere Dicke als etwa 500 µm oder etwa 1 mm oder etwa 2 mm aufweisen. Der Diamant kann dann eine hinreichende Dicke haben, um auch freistehend ohne anhaftendes Substrat einen stabilen Wafer zu bilden, um beispielsweise als Fenster für elektromagnetische Strahlung eingesetzt zu werden.

In einigen Ausführungsformen der Erfindung kann das Substrat einen Durchmesser von mehr als 5 cm aufweisen. In anderen Ausführungsformen der Erfindung kann das Substrat einen Durchmesser von mehr als 7,5 cm aufweisen. In wiederum anderen Ausführungsformen der Erfindung kann das Substrat einen Durchmesser von mehr als 10 cm aufweisen. In einigen Ausführungsformen der Erfindung kann der Durchmesser geringer sein als etwa 31 cm. In anderen Ausführungsformen der Erfindung kann der Durchmesser geringer sein als etwa 26 cm. In wiederum anderen Ausführungsformen der Erfindung kann das Substrat einen Durchmesser von weniger als etwa 10 cm aufweisen. Substrate mit dieser Größe können wirtschaftlich als Fenster für elektromagnetische Strahlung, als Wärmespreizer und/oder als Substrat für elektronische Bauelemente eingesetzt werden.

In einigen Ausführungsformen der Erfindung kann bei einer einzelnen Ausführung des vierten Verfahrensschritts eine Diamantschicht mit einer Schichtdicke von etwa 0,5 µm bis etwa 1 µm abgeschieden werden. In anderen Ausführungsformen der Erfindung kann eine einzelne Diamantschicht eine Schichtdicke von etwa 4 µm bis etwa 30 µm aufweisen. In wiederum anderen Ausführungsformen der Erfindung kann eine einzelne Diamantschicht eine Schichtdicke von etwa 1 µm bis etwa 4 µm aufweisen. In wiederum anderen Ausführungsformen der Erfindung kann eine einzelne Diamantschicht eine Schichtdicke von etwa 16 µm bis etwa 20 µm aufweisen. In wiederum anderen Ausführungsformen der Erfindung kann eine einzelne Diamantschicht eine Schichtdicke von etwa 4 µm bis etwa 15 µm aufweisen. Dies erlaubt einerseits eine gute Kontrolle der auftretenden mechanischen Spannungen und andererseits ein rasches Wachstum bis zur gewünschten Enddicke mit einer geringen Anzahl von Zyklen.

In einigen Ausführungsformen der Erfindung können die ersten vier bis acht Diamantschichten mit einer geringeren Schichtdicke abgeschieden werden als die nachfolgenden Diamantschichten. Hierdurch können anfängliche Gitterfehlanpassungen an der Grenzfläche zur Substratoberfläche reduziert und/oder die Kristallqalität an der Grenzfläche zum Substrat erhöht werden.

In einigen Ausführungsformen der Erfindung können die im vierten Verfahrensschritt abgeschiedenen Diamantschichten eine [100]-Orientierung aufweisen. In anderen Ausführungsformen der Erfindung können die im vierten Verfahrensschritt abgeschiedenen Diamantschichten eine [111]-Orientierung aufweisen. Die Kristallrichtung der Oberfläche der Diamantschicht wird dabei als Miller-Index angegeben. In einigen Ausführungsformen der Erfindung kann das teilweise Entfernen der Diamantschicht durch trockenchemisches Ätzen im dritten Verfahrensschritt zum Ausbilden von Pyramiden auf der Oberfläche führen. In einigen Ausführungsformen der Erfindung können diese Pyramiden zumindest eine Seitenfläche mit einer [111]-Orientierung aufweisen. In einigen Ausführungsformen der Erfindung können die Pyramiden eine in Normalenrichtung der Substratoberfläche gemessene Höhe von etwa 2 µm bis etwa 5 µm aufweisen. Die durch das trockenchemische Ätzen hervorgerufene Strukturierung der Diamantschichten kann zur Reduzierung der mechanischen Spannungen und damit zur verbesserten Kristallqualität der erfindungsgemäß abgeschiedenen Diamantschichten beitragen.

In einigen Ausführungsformen der Erfindung kann die letzte Diamantschicht nominell undotiert abgeschieden werden, wohingegen die darunterliegenden Schichten zumindest teilweise mit einem Dotierstoff versehen sind. Der Dotierstoff kann ausgewählt sein aus Stickstoff und/oder Phosphor und/oder Bor. Hierdurch können Schichten bzw. Raumbereiche innerhalb des Diamant hergestellt werden, welche eine vorgebbare Leitfähigkeit und/oder Farbzentren aufweisen. Die Farbzentren können in einigen Ausführungsformen der Erfindung Stickstoff-Vakanz-Zentren sein.

In einigen Ausführungsformen der Erfindung kann das Substrat nach der vollständigen Abscheidung des Diamant entfernt werden. Das Entfernen des Substrates kann durch nass- oder trockenchemisches Ätzen oder durch mechanische Bearbeitung erfolgen. Auf einem solchermaßen hergestellten Wafer kann nachfolgend Diamant mittels Homoepitaxie aus der Gasphase abgeschieden werden, um die Dicke des Diamant-Wafers weiter zu erhöhen. Aufgrund der homoepitaktischen Abscheidung können hierbei mechanische Spannungen in geringerem Maße auftreten oder vollständig eliminiert sein, so dass auch bei konventionellem Wachstum ohne Ätzschritte eine größere Schichtdicke erreicht werden kann.

In einigen Ausführungsformen der Erfindung kann der erzeugte Diamant monokristallin sein. Die hohe Kristallqualität monokristalliner Diamantschichten kann dabei gegenüber polykristallinen Diamantschichten einen geringeren Absorptionskoeffizienten aufweisen. Der Absorptionskoeffizient kann für Wellenlängen zwischen 680 nm und 780 nm zwischen etwa 0,25 cm⁻¹ und etwa 0,35 cm⁻¹ betragen.

Das vorgeschlagene Verfahren ermöglicht eine zuverlässige Kontrolle mechanischer Spannungen, so dass der so erhaltene Wafer geringe Krümmungen bzw. geringe Formtoleranzen aufweist. In einigen Ausführungsformen der Erfindung kann die maximale Abweichung der Medianfläche des Wafers von einer Referenzebene kleiner als 100 µm oder kleiner als 50 µm sein.

Nachfolgend soll die Erfindung anhand von Figuren ohne Beschränkung des allgemeinen Erfindungsgedankens näher erläutert werden. Dabei zeigt:
Figur 1 die Gasphasenabscheidung von Diamant in einer Niederdrucksynthese.
Figur 2 zeigt das Flussdiagramm eines beschriebenen Verfahrens.
Figur 3 zeigt den Querschnitt durch einen nach dem beschriebenen Verfahren hergestellten Wafer.
Figur 4 zeigt Fotolumineszenzspektren eines nach dem beschriebenen Verfahren hergestellten Wafers.
Figur 5 zeigt die Ergebnisse einer Röntgenstrukturanalyse eines nach dem beschriebenen Verfahren hergestellten Wafers als Röntgenintensität gegen den Einfallswinkel.
Figur 6 zeigt die Ergebnisse einer Röntgenstrukturanalyse als Phasendiagramm.

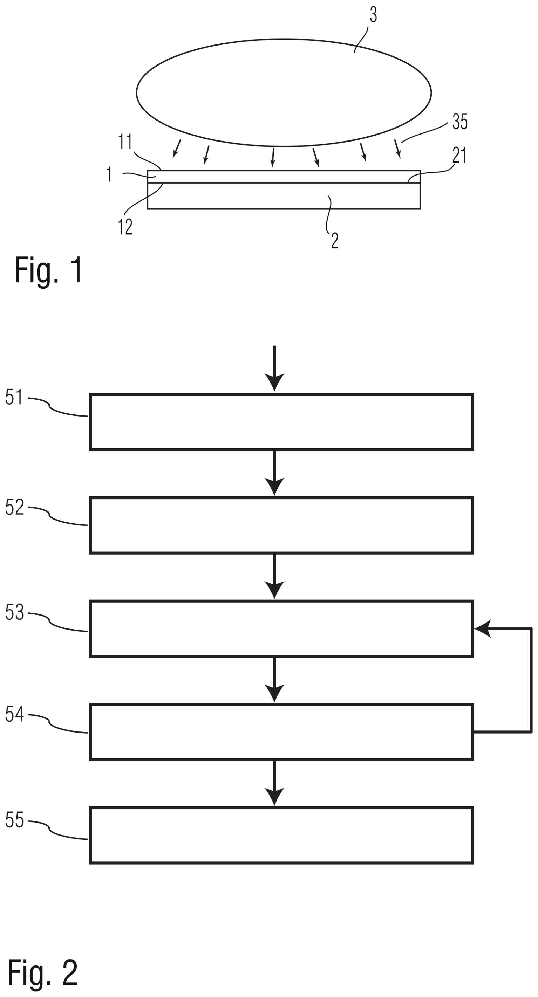

Figur 1 zeigt schematisch die Herstellung eines Wafers, welcher kristallinen Diamant enthält oder daraus besteht, mittels chemischer Gasphasenabscheidung. Dargestellt ist der Querschnitt durch ein Substrat 2, welches eine erste Seite 21 aufweist. Der ersten Seite 21 gegenüberliegend befindet sich ein Plasma 3. Das Plasma 3 wird durch Einwirkung von Mikrowellenstrahlung auf ein Arbeitsgas erzeugt, wobei die Mikrowellenstrahlung das Arbeitsgas zumindest teilweise ionisiert. Hierzu befindet sich das Arbeitsgas und das Substrat 2 in einer Vakuumkammer, welche Teil eines Mikrowellenresonators ist, das sich innerhalb eines Mikrowellenresonators befindet.

In Abhängigkeit der Zusammensetzung des Arbeitsgases im Plasma 3 kann aus dem Plasma entweder Diamant abgeschieden werden oder eine bereits abgeschiedene Diamantschicht trockenchemisch geätzt werden. Hierzu wirken Ionen, Neutralteilchen, Elektronen und/oder Photonen 35 auf die erste Seite 21 des Substrates 2 ein. Die Energie auftreffender geladener Teilchen kann durch Anlegen eines elektrischen Potentials mittels einer nicht dargestellten Spannungsquelle beeinflusst werden.

Die Bearbeitung des Substrates 2 durch das Plasma 3 führt zur Abscheidung von Diamant 1. Der Diamant 1 weist dabei eine erste Seite 11 und eine gegenüberliegende zweite Seite 12 auf. Die zweite Seite 12 ist in Kontakt mit der ersten Seite 21 des Substrates 2. Die erste Seite 11 ist dem Plasma 3 zugewandt und wird in Abhängigkeit der Zusammensetzung des Arbeitsgases entweder überwachsen oder durch trockenchemisches Ätzen teilweise entfernt. Während des Wachstums und/oder Ätzens kann das Substrat 2 mittels einer nicht dargestellten Heizeinrichtung auf eine erhöhte Temperatur gebracht werden. Diese kann zwischen etwa 800° und etwa 900° oder zwischen etwa 840° und etwa 860° oder zwischen etwa 650° und etwa 1200° betragen.

Das Arbeitsgas 3 kann einen Druck von etwa 50 mbar bis etwa 200 mbar aufweisen. In anderen Ausführungsformen der Erfindung kann der Druck zwischen etwa 70 mbar und etwa 90 mbar betragen. In wiederum anderen Ausführungsformen der Erfindung kann der Druck zwischen etwa 110 mbar und etwa 130 mbar betragen.

Das Arbeitsgas des Plasmas 3 kann während der Abscheidung einer Diamantschicht im Wesentlichen Wasserstoff enthalten, welchem etwa 1% bis etwa 5% Methan zugesetzt werden. In anderen Ausführungsformen der Erfindung können auch andere Kohlenwasserstoffe verwendet werden, beispielsweise Ethan oder Acetylen. Daneben können dem Arbeitsgas Dotierstoffe zugesetzt werden, beispielsweise Stickstoff, Phosphor oder Bor. Die Dotierstoffe können in einer Konzentration von etwa 1000 ppm bis etwa 4000 ppm im Arbeitsgas vorliegen. Daneben kann das Arbeitsgas unvermeidbare Verunreinigungen enthalten, beispielsweise weitere Kohlenwasserstoffe oder Argon. In einigen Ausführungsformen der Erfindung kann dem Arbeitsgas etwa 0,1% bis etwa 1% oder etwa 0,2% bis etwa 0,4% Sauerstoff zugesetzt werden.

Zum trockenchemischen Ätzen der ersten Seite 11 der Diamantschicht 1 kann ein Arbeitsgas verwendet werden, welches im Wesentlichen aus Wasserstoff besteht und welches etwa 1,5% bis etwa 2,5% Sauerstoff enthält. Daneben kann das Arbeitsgas unvermeidbare Verunreinigungen enthalten, beispielsweise Kohlenwasserstoffe, Argon oder Stickstoff. Durch zyklisches Ändern der Zusammensetzung des Arbeitsgases und gegebenenfalls Anpassen der Mikrowellenleistung und/oder der Temperatur des Substrates 2 kann zyklisch zwischen der chemischen Gasphasenabscheidung einer Diamantschicht und deren teilweisen Entfernens durch trockenchemisches Ätzen umgeschaltet werden. Hierzu kann eine Steuer- oder Regeleinrichtung vorgesehen sein, welche das vorgeschlagene Verfahren implementiert.

Anhand der Figur 2 wird das vorgeschlagene Verfahren anhand eines Flussdiagramms näher erläutert. Im ersten Verfahrensschritt 51 wird ein Substrat 2 bereitgestellt, welches beispielsweise einen monokristallinen Silizium-Wafer enthält oder daraus besteht. Der Silizium-Wafer kann mit einer keramischen Schicht beschichtet sein. Die keramische Schicht kann in einigen Ausführungsformen der Erfindung Yttrium-stabilisiertes Zirkonoxid und/oder Aluminiumnitrid enthalten oder daraus bestehen. Auf dieser keramischen Schicht kann metallisches Iridium abgeschieden sein. Der Silizium-Wafer kann eine Dicke von etwa 2 mm bis etwa 3 mm oder von etwa 1 mm bis etwa 5 mm aufweisen. Die darauf abgeschiedenen Schichten können eine Gesamtschichtdicke von etwa 80 nm bis etwa 200 nm oder von etwa 110 nm bis etwa 130 nm aufweisen.

Im ersten Verfahrensschritt 51 wird auf diesem Substrat weiterhin eine Nukleationsschicht erzeugt. Das Abscheiden der Nukleationsschicht kann dadurch erfolgen, dass dem das Plasma bildenden Arbeitsgas ein Methananteil von etwa 1% bis etwa 5% zugeführt wird, während an das Substrat 2 eine negative elektrische Vorspannung angelegt ist. Hierdurch entstehen in an sich bekannter Weise Nukleationskeime, welche das Abscheiden einer kristallinen Diamantschicht im nachfolgenden zweiten Verfahrensschritt ermöglichen.

Im zweiten Verfahrensschritt 52 wird die im vorangegangenen ersten Verfahrensschritt 51 erzeugte Nukleationsschicht mit einer ersten Diamantschicht überwachsen. Das Abscheiden der ersten Diamantschicht erfolgt durch chemische Gasphasenabscheidung, wie vorstehend im Zusammenhang mit Figur 1 beschrieben. Diese erste Diamantschicht kann mit einer Schichtdicke von etwa 0,5 µm bis etwa 1 µm abgeschieden werden. In einigen Ausführungsformen der Erfindung kann die erste Diamantschicht geschlossen sein, so dass diese die erste Seite 21 des Substrates 2 vollständig oder annähernd vollständig bedeckt, ohne unzulässig große mechanische Spannungen aufzuweisen.

Im nachfolgenden dritten Verfahrensschritt wird diese erste Diamantschicht durch trockenchemisches Ätzen teilweise entfernt. Das trockenchemische Ätzen kann die Wirkung haben, dass die im zweiten Verfahrensschritt 52 abgeschiedene Diamantschicht im Anschluss eine geringere Dicke aufweist. In anderen Ausführungsformen der Erfindung können sich auf der Diamantschicht Pyramiden oder pyramidenartige Strukturen ausbilden. Diese können Seitenflächen aufweisen, welche zumindest teilweise eine [111]-Orientierung aufweisen.

Im nachfolgenden vierten Verfahrensschritt 54 wird die im vorangegangenen Verfahrensschritt 53 geätzte Diamantschicht homoepitaktisch durch chemische Gasphasenabscheidung mit einer weiteren Diamantschicht überwachsen. Diese zweite Diamantschicht kann eine Schichtdicke von etwa 4 µm bis etwa 30 µm oder von etwa 16 µm bis etwa 20 µm oder von etwa 4 µm bis etwa 15 µm aufweisen. Die dem Plasma 3 zugewandte erste Seite 11 kann eine [100]-Orientierung oder eine [111]-Orientierung aufweisen.

Danach werden der dritte Verfahrensschritt 53 und der vierte Verfahrensschritt 54 zyklisch wiederholt, d.h., jede abgeschiedene Diamantschicht wird nachfolgend durch trockenchemisches Ätzen teilweise entfernt, ehe diese mit einer weiteren Diamantschicht überwachsen wird. Die ersten vier bis acht Diamantschichten können in geringerer Schichtdicke abgeschieden werden als die nachfolgenden Diamantschichten. In der Summe können die Verfahrensschritte 53 und 54 etwa 10 Mal bis etwa 80 Mal oder auch noch häufiger wiederholt werden, bis der Diamant 1 die gewünschte Schichtdicke aufweist. Diese kann in einigen Ausführungsformen der Erfindung mehr als 200 µm oder mehr als 250 µm oder mehr als 300 µm betragen.

Im letzten Verfahrensschritt 55 kann das Substrat 2 durch nass- oder trockenchemisches Ätzen und/oder durch mechanische Bearbeitung entfernt werden, so dass der Diamant 1 als freistehender Wafer aus monokristallinem Diamant vorliegt. Dieser kann nachfolgend weiterbearbeitet werden, beispielsweise durch Abscheiden weiterer Diamantschichten bis zu einer gewünschten Enddicke, welche auch mehrere Millimeter betragen kann.

### 1. Ausführungsbeispiel

Auf 2 mm oder 3 mm dicken Silizium-Wafern wurde Yttrium-stabilisiertes Zirkonoxid mit einer Schichtdicke von 90 nm abgeschieden. Darauf wurde eine Schicht aus 30 nm metallischen Iridiums aufgebracht. Das Arbeitsgas wurde bei einem Druck von 120 mbar mittels Mikrowellenstrahlung von 915 MHz ionisiert.

Das Ätzen der Diamantschichten im dritten Verfahrensschritt 53 erfolgte mit folgenden Parametern:

| **Parameter** | **Wert** |
|---|---|
| Substrattemperatur | 820°C - 840°C |
| Sauerstoff-Anteil im Arbeitsgas | 2,0% |
| Ätz-Zeit je Zyklus (53) | 4 Stunden (erste 6 Zyklen: 2 h) |

Das Wachstum der Diamantschichten im vierten Verfahrensschritt 54 erfolgte mit folgenden Parametern:

| **Parameter** | **Wert:** |
|---|---|
| Substrattemperatur | 840°C - 860°C |
| Methan-Anteil im Arbeitsgas | 1,25% |
| Wachstumszeit je Zyklus (54) | 5 Stunden (erste 6 Zyklen: 4 h) |
| Stickstoff-Anteil im Arbeitsgas | 3040 ppm |
| Sauerstoff-Anteil im Arbeitsgas | **0,15%** |

Nach 38 Zyklen mit einer Gesamtdauer von 385 Stunden konnte Diamant mit einer Schichtdicke von 300 µm abgeschieden werden. Dieser lies sich ohne Beschädigung vom Substrat lösen. Die Krümmung des so hergestellten Wafers betrug mehr als 10 m. Mittels Röntgenstrukturanalayse (XRD) konnte nachgewiesen werden, dass der Diamant einkristallin war.

### 2. Ausführungsbeispiel

Auf 2 mm oder 3 mm dicken Silizium-Wafern wurde wiederum Yttrium-stabilisiertes Zirkonoxid mit einer Schichtdicke von 90 nm abgeschieden. Darauf wurde eine Schicht aus 30 nm metallischen Iridiums aufgebracht. Das Arbeitsgas wurde bei einem Druck von 120 mbar mittels Mikrowellenstrahlung von 915 MHz ionisiert.

Das Ätzen der Diamantschichten im dritten Verfahrensschritt 53 erfolgte mit folgenden Parametern:

| **Parameter** | **Wert** |
|---|---|
| Substrattemperatur | 820°C - 840°C |
| Sauerstoff-Anteil im Arbeitsgas | 2,0% |
| Ätz-Zeit je Zyklus (53) | 4 Stunden (erste 6 Zyklen: 2 h) |

Das Wachstum der Diamantschichten im vierten Verfahrensschritt 54 erfolgte mit folgenden Parametern:

| **Parameter** | **Wert:** |
|---|---|
| Substrattemperatur | 840°C - 860°C |
| Methan-Anteil im Arbeitsgas | 1,75% |
| Wachstumszeit je Zyklus (54) | 4 Stunden (erste 6 Zyklen: 2,5 h) |
| Stickstoff-Anteil im Arbeitsgas | 3040 ppm |
| Sauerstoff-Anteil im Arbeitsgas | 0,15% |

Nach 30 Zyklen mit einer Gesamtdauer von 215 Stunden konnte Diamant mit einer Schichtdicke von 500 µm abgeschieden werden. Dieser lies sich ohne Beschädigung vom Substrat lösen. Die Krümmung des so hergestellten Wafers betrug mehr als 10 m. Mittels Röntgenstrukturanalayse (XRD) konnte nachgewiesen werden, dass der Diamant einkristallin war.

### 3. Ausführungsbeispiel

Das Substrat entspracht demjenigen der 1. und 2. Ausführungsbeispiele. Das Arbeitsgas wurde bei einem Druck von 80 mbar mittels Mikrowellenstrahlung von 2,45 GHz ionisiert.

Das Ätzen der Diamantschichten im dritten Verfahrensschritt 53 erfolgte mit folgenden Parametern:

| **Parameter** | **Wert** |
|---|---|
| Substrattemperatur | 680°C - 720°C |
| Sauerstoff-Anteil im Arbeitsgas | 2,0% |
| Ätz-Zeit je Zyklus (53) | 0,5 Stunden |

Das Wachstum der Diamantschichten im vierten Verfahrensschritt 54 erfolgte mit folgenden Parametern:

| **Parameter** | **Wert:** |
|---|---|
| Substrattemperatur | 760°C - 800°C |
| Methan-Anteil im Arbeitsgas | 3,3 % |
| Wachstumszeit je Zyklus (54) | 4 Stunden (erster Zyklus: 10 h) |
| Stickstoff-Anteil im Arbeitsgas | 90 ppm |
| Sauerstoff-Anteil im Arbeitsgas | 0,4% |

Nach 14 Zyklen mit einer Gesamtdauer von 66 Stunden konnte Diamant mit einer Schichtdicke von 250 µm abgeschieden werden. Dieser lies sich ohne Beschädigung vom Substrat lösen. Die Krümmung des so hergestellten Wafers betrug mehr als 10 m. Mittels Röntgenstrukturanalayse (XRD) konnte nachgewiesen werden, dass der Diamant einkristallin war.

Die optische Transparenz der hergestellten Diamant-Wafer wurde mit UV/Vis-Messungen des Absorptionskoeffizienten von 680 nm bis 760 nm analysiert, welcher im Ergebnis weniger als 0,3 cm⁻¹ beträgt.

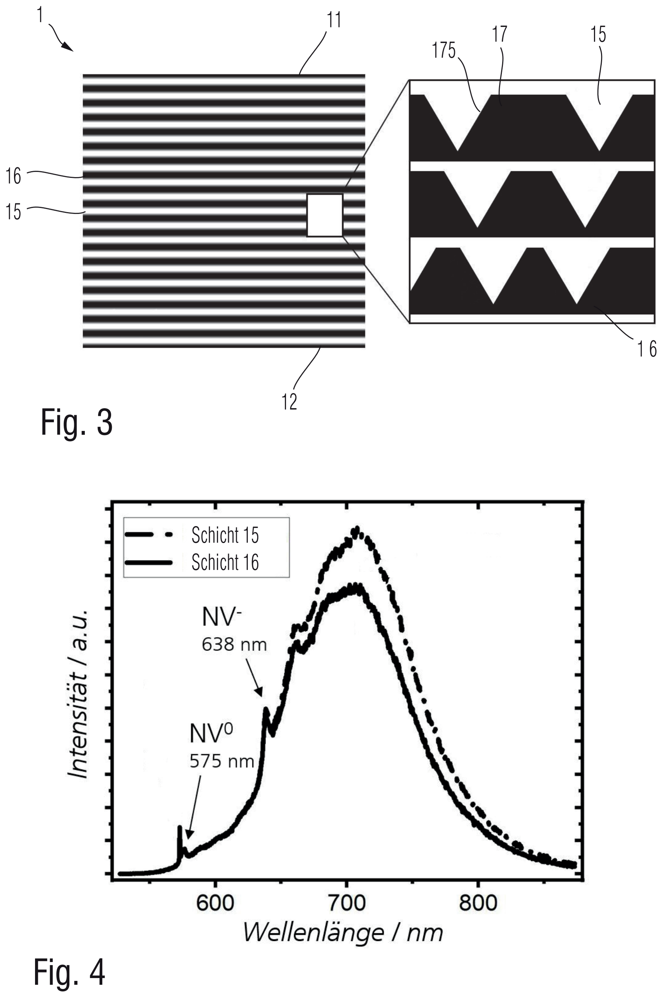

Figur 3 zeigt einen Querschnitt durch einen erfindungsgemäß hergestellten Diamant-Wafer 1. In Figur 3 ist die erste Seite 11 oben dargestellt. Die gegenüberliegende zweite Seite 12, welche sich während des Wachstums in Kontakt mit dem Substrat 2 befunden hat, ist in Figur 3 unten dargestellt. Wie Figur 3 zeigt, ist der Diamant 1 aus einer Mehrzahl von Schichten 15 und 16 zusammengesetzt, welche aufgrund der zyklischen Abfolge der Verfahrensschritte 53 und 54 zyklisch innerhalb des Diamant 1 angeordnet sind.

Figur 3 zeigt weiterhin eine vergrößerte Darstellung von drei Schichten. In dieser Vergrößerung ist ersichtlich, dass durch das trockenchemische Ätzen in eine Diamantschicht Pyramiden 17 eingebracht werden, welche zumindest einige Seitenflächen 175 aufweisen, welche eine [111]-Orientierung aufweisen. Die erste Seite 11 bzw. die auf die Pyramiden 17 abgeschiedene weitere Diamantschicht 15 kann in einigen Ausführungsformen der Erfindung eine [100]-Orientierung aufweisen. Hierdurch kann das Wachstum beschleunigt und/oder der Einbau von Dotierstoffen verbessert sein. Durch die vorgeschlagene Schichtstruktur werden mechanische Spannungen innerhalb des Diamant 1 effektiv unterbunden, so dass dieser als freistehender Wafer auch großflächig bereitgestellt werden kann, beispielsweise mit einem Durchmesser von mehr als 5 cm, mehr als 7,5 cm oder mehr als 10 cm.

Figur 4 zeigt Fotolumineszenzmessungen an dem in Figur 3 schematisch dargestellten Wafer. Dargestellt ist die Intensität des Lumineszenzlichtes auf der Ordinate gegen die Wellenlänge in Nanometern auf der Abszisse. Figur 4 zeigt die Zero-Phonon-Line des neutralen und negativ geladenen Stickstoff-Vakanz-Zentrums sowie die zugehörigen Phononen-Seitenbanden für die im dritten Verfahrensschritt 53 durch Ätzen strukturierten und die im vierten Verfahrensschritt 54 abgeschiedenen, unstrukturierten Diamantschichten 15 und 16. Wie aus Figur 4 ersichtlich ist, sind die Intensitäten der beiden Schichten im Fotolumineszenzspektrum nur bei hohen Wellenlängen oberhalb von 635 nm verschieden, während sie unterhalb von 635 nm konstant bleiben. Dies bedeutet, dass durch das beschriebene Verfahren ein kristalliner Diamant mit hoher Kristallqualität erzeugt werden kann.

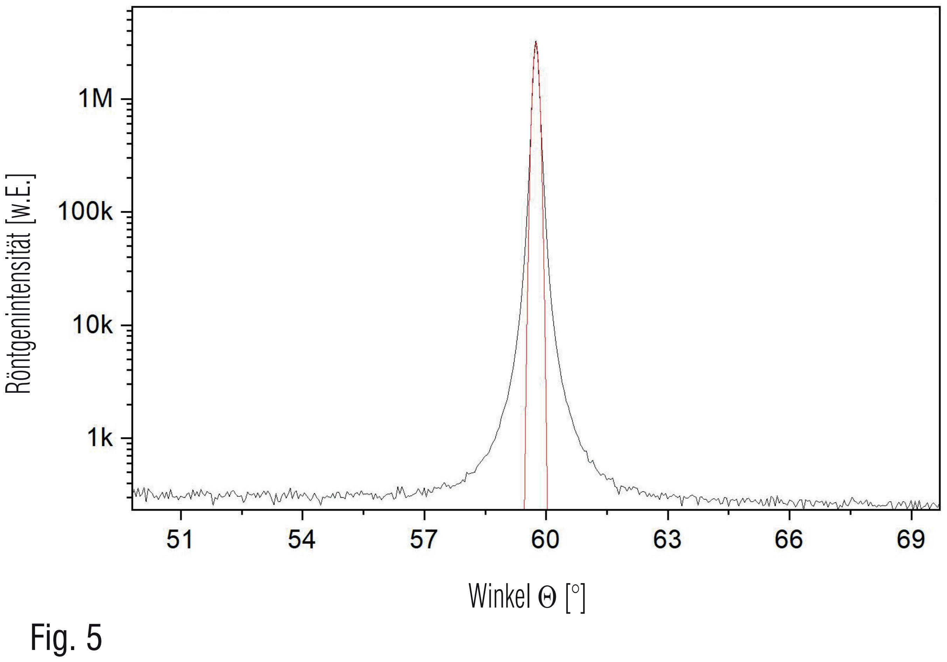

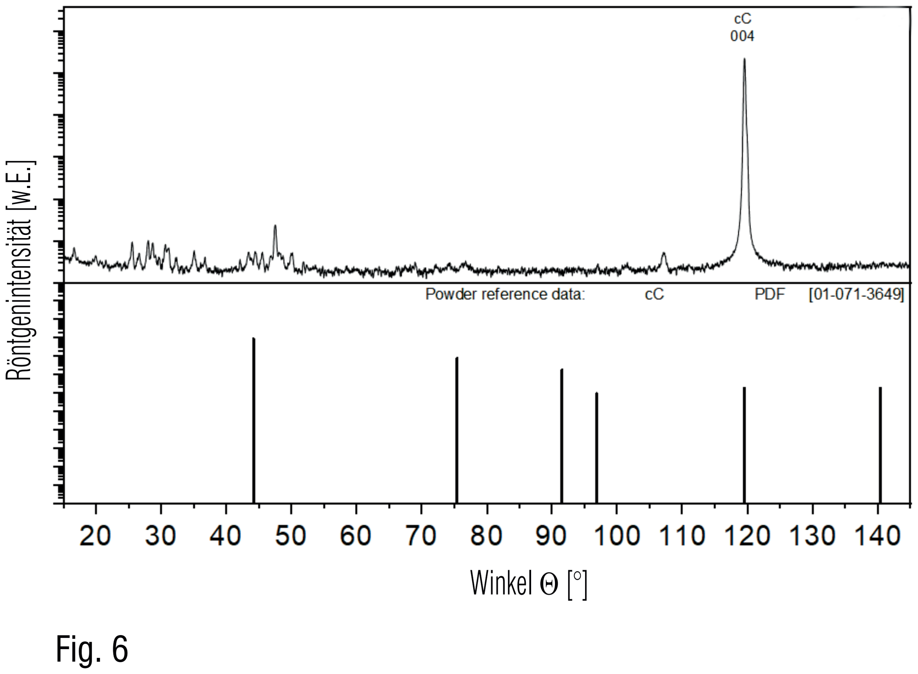

Figur 5 und Figur 6 zeigt die Ergebnisse einer Röntgenstrukturanalyse (XRD) einer mit dem vorgeschlagenen Verfahren erzeugten Diamantschicht mit einer Schichtdicke von 255 µm, welche im dritten Ausführungsbeispiel hergestellt wurde. Dargestellt ist in Figur 5 ein Winkelscan (rocking curve), wobei der Einfallswinkel auf der Abszisse und die gemessene Röntgenintensität auf der Ordinate dargestellt ist. Figur 6 zeigt die Ergebnisse eines Phasendiffraktogramms.

Die Messdaten der Figur 5 zeigen eine Gauß-Verteilung der Röntgenintensität gegen den Winkel mit einer Breite (FWHM) von 0,13°. Die Messwerte zeigen damit die hohe Kristallqualität der erfindungsgemäß hergestellten einkristallinen Diamantschichten.

Figur 6 zeigt die Ergebnisse eines Phasendiffraktogramms einer Röntgenstrukturanalyse (XRD) einer mit dem vorgeschlagenen Verfahren erzeugten Diamantschicht mit einer Schichtdicke von 255 µm, welche im dritten Ausführungsbeispiel hergestellt wurde. Dargestellt ist ein Winkelscan, wobei der Einfallswinkel auf der Abszisse und die gemessene Röntgenintensität auf der Ordinate dargestellt ist.

Die Messdaten der Figur 6 zeigen einen Intensitätsausschlag bei etwa 119,5°. Dies ist der mit in [100]-Orientierung gewachsenem Diamant assoziierte cC004 Ausschlag. Ein polykristalliner Diamantfilm würde demgegenüber weitere Ausschläge bei 43,9° ([111]), 75,3°([220]), 91,5° ([311]) und 140,6°([331]) zeigen.

Selbstverständlich ist die Erfindung nicht auf die dargestellten Ausführungsformen beschränkt. Die vorstehende Beschreibung ist daher nicht als beschränkend, sondern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Die nachfolgenden Ansprüche sind nicht so zu verstehen, dass ein genanntes Merkmal in jeder Ausführungsform der Erfindung vorhanden sein muss. Sofern die Ansprüche und die vorstehende Beschreibung "erste" und "zweite" Ausführungsformen oder "erste" und "zweite" Merkmale definieren, so dient diese Bezeichnung der Unterscheidung zweier gleichartiger Ausführungsformen oder Merkmale, ohne eine Rangfolge festzulegen.

## Patentansprüche

1. Verfahren zur heteroepitaktischen Abscheidung von Diamant (1) auf einem Substrat (2) mittels chemischer Gasphasenabscheidung (CVD), enthaltend folgende Schritte:
a. Erzeugen (51) einer Nukleationsschicht auf dem Substrat (2);
b. Überwachsen (52) der Nukleationsschicht mit einer Diamantschicht (15, 16) durch chemische Gasphasenabscheidung;
c. Teilweises Entfernen (53) der Diamantschicht (15, 16) durch trockenchemisches Ätzen, wobei das trockenchemische Ätzen durch Einwirken eines Plasmas (3) erfolgt, welches Wasserstoff und Sauerstoff enthält oder daraus besteht;
d. Überwachsen (54) der Diamantschicht (15, 16) durch chemische Gasphasenabscheidung
e. Zyklisches Wiederholen der Verfahrensschritte c und d.

2. Verfahren nach Anspruch 1, **dadurch gekennzeichnet, dass** die Verfahrensschritte c und d etwa 10 bis etwa 80 mal oder zwischen etwa 20 und etwa 60 mal oder zwischen etwa 30 und etwa 60 mal wiederholt werden.

3. Verfahren nach Anspruch 1 oder 2, **dadurch gekennzeichnet, dass** die Verfahrensschritte c und d so lange wiederholt werden, dass der Diamant (1) eine Gesamtdicke von mehr als 200 µm oder mehr als 300 µm oder mehr als 400 µm aufweist.

4. Verfahren nach Anspruch 1 bis 3, **dadurch gekennzeichnet, dass** das Substrat (2) einen Durchmesser von mehr als 5 cm oder mehr als 7,5 cm oder mehr als 10 cm aufweist und/oder
dass das Substrat (2) einen Durchmesser von weniger als 31 cm oder weniger als 26 cm oder weniger als 10 cm aufweist.

5. Verfahren nach einem der Ansprüche 1 bis 4, **dadurch gekennzeichnet, dass** das Substrat (2) Silizium und/oder Yttrium und/oder Zirkonoxid und/oder Aluminiumnitrid und/oder Strontiumtitanat enthält oder daraus besteht und/oder
dass das Substrat mit einer Beschichtung versehen ist oder mit einer Beschichtung versehen wird und/oder dass das Substrat mit Iridium beschichtet ist oder beschichtet wird.

6. Verfahren nach einem der Ansprüche 1 bis 5, **dadurch gekennzeichnet, dass** die einzelne Diamantschicht (15, 16) mit einer Schichtdicke von etwa 0,5 µm bis etwa 1 µm oder einer Schichtdicke von etwa 4 µm bis etwa 30 µm oder einer Schichtdicke von etwa 1 µm bis etwa 4 µm oder einer Schichtdicke von etwa 16 µm bis etwa 20 µm oder einer Schichtdicke von etwa 4 µm bis etwa 15 µm abgeschieden wird.

7. Verfahren nach einem der Ansprüche 1 bis 6, **dadurch gekennzeichnet,dass** die ersten 4 - 8 Diamantschichten (15, 16) mit einer geringeren Schichtdicke abgeschieden werden als die nachfolgenden Diamantschichten (25, 26).

8. Verfahren nach einem der Ansprüche 1 bis 7, **dadurch gekennzeichnet, dass** die einzelne Diamantschicht (15, 16) mit einer [100]-Orientierung abgeschieden wird und/oder dass das teilweises Entfernen der Diamantschicht (15, 16) durch trockenchemisches Ätzen das Ausbilden von Pyramiden (17) auf der Oberfläche bewirkt, welche zumindest eine Seitenfläche (175) mit [111]-Orientierung aufweisen und/oder welche eine Höhe von etwa 2 µm bis etwa 5 µm aufweisen.

9. Verfahren nach einem der Ansprüche 1 bis 8, **dadurch gekennzeichnet, dass** die letzte Diamantschicht (15, 16) nominel undotiert abgeschieden wird und die darunterliegenden Schichten zumindest teilweise mit einem Dotierstoff abgeschieden werden.

10. Verfahren nach einem der Ansprüche 1 bis 9, **dadurch gekennzeichnet, dass** das Abscheiden von Diamant in den Verfahrensschritten b und d durch Einwirken eines Plasmas (3) erfolgt, welches Wasserstoff und einen Kohlenwasserstoff enthält oder daraus besteht.

11. Verfahren nach einem der Ansprüche 1 bis 10, **dadurch gekennzeichnet, dass** das Substrat (2) nach der Abscheidung von Diamant (1) entfernt (55) wird.

12. Wafer, hergestellt nach einem Verfahren nach einem der Ansprüche 1 bis 11.

13. Wafer nach Anspruch 12, **dadurch gekennzeichnet, dass** dieser einen Durchmesser von 5 cm oder mehr und
eine Dicke von 200 µm oder mehr aufweist, wobei der Wafer Diamant enthält oder daraus besteht, welcher monokristallin ist und wobei
die maximale Abweichung der Median-Fläche des Wafers von einer Referenzebene kleiner als 100 µm ist.

14. Wafer nach Anspruch 12 oder 13, **dadurch gekennzeichnet, dass** dieser einen Durchmesser von mehr als 5 cm oder mehr als 7,5 cm oder mehr als 10 cm aufweist und/oder dass dieser einen Durchmesser von weniger als 31 cm oder weniger als 26 cm oder weniger als 10 cm aufweist

15. Wafer nach einem der Ansprüche 12 bis 14, **dadurch gekennzeichnet, dass** dieser einzelne Diamantschichten (15, 16) mit einer Schichtdicke von etwa 0,5 µm bis etwa 1 µm oder einer Schichtdicke von etwa 1 µm bis etwa 4 µm oder einer Schichtdicke von etwa 4 µm bis etwa 30 µm oder einer Schichtdicke von etwa 16 µm bis etwa 20 µm oder einer Schichtdicke von etwa 4 µm bis etwa 15 µm enthält oder daraus besteht.
